**Europäisches Patentamt**

**European Patent Office**

**Office européen des brevets**

(19)

(11) Veröffentlichungsnummer: **0 002 199 B1**

(12) **EUROPÄISCHE PATENTSCHRIFT**

(45) Veröffentlichungstag der Patentschrift:
07.01.81

(21) Anmeldenummer: 78101344.6

(22) Anmeldetag: 10.11.78

(51) Int. Cl.³: **G 03 B 41/00**, G 03 F 1/00,
G 03 F 7/26

(54) Belichtungsmaske und Projektionsbelichtungssystem.

(30) Priorität: 05.12.77 US 857632

(43) Veröffentlichungstag der Anmeldung:
13.06.79 Patentblatt 79/12

(45) Bekanntmachung des Hinweises auf die Patenterteilung:
07.01.81 Patentblatt 81/1

(84) Benannte Vertragsstaaten:
DE FR GB

(56) Entgegenhaltungen:
NL-A-7 710 996
US-A-4 037 111
IBM TECHNICAL DISCLOSURE BULLETIN, 1
Vol 18, Nr. 10, März 1976,
New York, USA
G.G. VIA "Package mask for photolithography", Seite
3360

(73) Patentinhaber: **International Business Machines
Corporation, Armonk, N.Y. 10504 (US)**

(72) Erfinder: **Shea, Vincent, 179 Van Wagner Road,
Poughkeepsie New York 12603 (US)**
Erfinder: **Wojcik, Walter Joseph, Mark Vincent Drive,
Poughkeepsie New York 12603 (US)**

(74) Vertreter: **Teufel, Fritz, Dipl.-Phys., Schönaicher
Strasse 220, D-7030 Böblingen (DE)**

Belichtungsmaske und Projetkionsbelichtungssystem

Die Erfindung betrifft eine Belichtungsmaske für Projektionsbelichtungssysteme und ein damit ausgestattetes Projektionsbelichtungssystem.

Bei der Herstellung integrierter Schaltkreise werden die verschiedenen Schaltelemente und Leitungsverbindungen unter Verwendung von Belichtungsmasken hergestellt, mit denen das Halbleitersubstrat überall dort abgedeckt wird, wo keine Einwirkung in dem jeweiligen Prozessschritt erfolgen soll, beispielsweise beim Ätzen oder beim Niederschlagen von Metallschichten.

Zur Herstellung der Prozessmasken aus Photolack wird ein Substrat mit einer Photolackschicht überzogen und darauf das gewünschte Muster erzeugt, indem die Schicht mit ultraviolettem Licht belichtet wird, das durch eine Belichtungsmaske hindurchtritt. Die belichteten Gebiete werden dabei im Fall eines negativen Photolacks unlöslich gemacht, im Fall eines positiven Photolacks bleiben sie löslich. Die löslichen Bereiche werden dann mit einem Entwickler entfernt, so dass die betreffenden Gebiete des Substrats zur Bearbeitung freigelegt sind. Die Belichtungsmasken bestehen gewöhnlich aus einem durchsichtigen Substrat, auf dessen einer Oberfläche ein Muster aus undurchsichtigen Bereichen, beispielsweise aus Silber oder Chrom, hergestellt wird.

Bisher wurden drei Arten von Belichtungsverfahren benutzt. Das häufigste Verfahren ist das sog. Kontaktbelichtungsverfahren, bei dem die das Muster tragende Maskenoberfläche in Kontakt mit der Photolackschicht gebracht wird. Der Nachteil hierbei ist die begrenzte Lebensdauer der Maske infolge aufgenommener Schmutzteilchen und die physikalische Beschädigung der Maske durch den Kontakt zwischen Maske und Substrat. Die Bildgrösse ist ausserdem auf eine 1:1-Reproduktion beschränkt. Das sog. Schattenwurfbelichtungsverfahren (proximity printing) soll die Beschädigung durch den Kontakt verringern. Die Bildgrösse ist dabei ebenfalls auf eine 1:1-Reproduktion beschränkt; als neues Problem treten bei diesem kontaktlosen Belichtungsverfahren Beugungseffekte des Lichtes auf, die zu einer Verringerung der Auflösung führen und Geisterbilder hervorrufen. Vor kurzem wurde das Projektionsbelichtungsverfahren mit hochwertigen optischen Einrichtungen eingeführt. Die Trennung von Maske und Substrat führt dabei nicht nur wie im Fall des Schattenwurfbelichtungsverfahrens zu einer längeren Maskenlebensdauer, sondern ermöglicht auch neben der 1:1-Reproduktion eine Verringerung der Bildgrössen auf dem Substrat. Das Maskenbild kann beispielsweise zwei- bis zehnmal so gross sein wie das auf dem Substrat erzeugte Bild. Die grösseren Masken erleichtern die Herstellung und die Prüfung. Von Vorteil ist weiterhin, dass Fehler in der Maske im Bild auf dem Substrat kleiner werden, so dass auch Maskenfehler unschädlich sind, die bei einer 1:1-Vergrösserung nicht mehr tragbar wären. Ein Nachteil, der bei Projektionsbelichtungsverfahren festgestellt wurde, besteht in deren Empfindlichkeit gegen Schmutzteilchen, die sich auf den durchsichtigen Gebieten der Maskenoberfläche ansammeln. Bei der genauen Abbildung des Maskenmusters auf die Oberfläche der Photolackschicht werden auch die Verunreinigungen und Schmutzteilchen mit optimaler Auflösung und Kontrast auf der Substratebene abgebildet und beeinflussen so den Photolack. Bei Systemen mit einer Verkleinerung der Bildgrösse tritt das Problem infolge des relativ grösseren Maskengebiets verschärft auf. Die Wahrscheinlichkeit, Verunreinigungsteilchen mit einer zur Abbildung ausreichenden Grösse auf den durchsichtigen Maskengebieten zu finden, steigt daher sogar in Reinräumen stark an.

In der Veröffentlichung IBM Technical Disclosure Bulletin, Band 18, Nr. 10, S. 3360 ist eine Belichtungsmaske angegeben, die in eine Polymerschicht eingebettet ist; Fehler in dieser Schicht, z.B. Lufteinschlüsse, beeinträchtigen die optische Qualität des Belichtungssystems. Die relativ grosse Schichtdicke muss bei der Auslegung des Belichtungssystems berücksichtigt werden.

Die Erfindung stellt sich daher die Aufgabe, eine Belichtungsmaske und ein Projektionsbelichtungssystem anzugeben, bei denen Verunreinigungen nicht abgebildet werden; die Maske muss dabei so aufgebaut sein, dass sie leicht herzustellen ist und die optischen Eigenschaften des Belichtungssystems möglichst wenig beeinflusst.

Diese Aufgabe wird durch die im Hauptanspruch gekennzeichnete Erfindung gelöst; Ausgestaltungen der Erfindung sind in den Unteransprüchen gekennzeichnet.

In einem Ausführungsbeispiel der Erfindung wird bei einem Projektionsbelichtungssystem die auf einer lichtempfindlichen Schicht abzubildende Belichtungsmaske durch eine durchsichtige Folie geschützt, deren Dicke 0,2 bis 6 $\mu$m beträgt und die durch Abstandsglieder in einem optisch grossen Abstand von ungefähr 1 bis 125 mm von der Maskenoberfläche gehalten wird. Schmutzteilchen auf der Oberfläche der Folie werden nicht scharf abgebildet und erscheinen somit nicht auf der lichtempfindlichen Schicht. Eine Folie kann weiterhin zum Schutz der lichtempfindlichen Schicht in der Bildebene verwendet werden.

Diese dünne Schutzfolie über der Belichtungsmaske beeinflusst die optischen Eigenschaften des Belichtungssystems nicht.

Ein Ausführungsbeispiel der Erfindung wird nun an Hand von 5 Zeichnungen näher erläutert. Es zeigen:

Fig. 1 die schematische Darstellung eines optischen Projektionsbelichtungssystems, dessen Maske eine Schutzfolie trägt,

Fig. 2 die schematische Seitenansicht einer Belichtungsmaske mit einer Schutzfolie,

Figuren 3A und 3B schematische Darstellungen der Herstellungschritte einer Schutzfolie,

Fig. 4 eine graphische Darstellung des notwendigen Abstands der Schutzfolie von der Belichtungsmaske, wenn verhindert werden soll, dass Verunreinigungsteilchen einer bestimmten Grösse abgebildet werden.

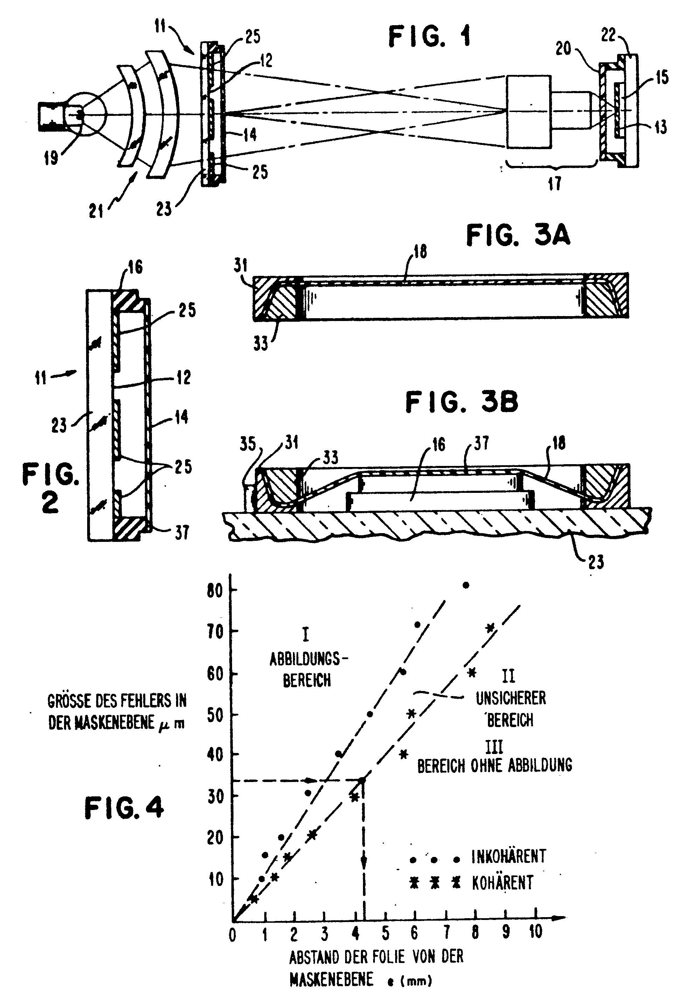

Fig. 1 zeigt ein Projektionsbelichtungssystem, bei dem ein verkleinertes Bild einer Belichtungsmaske 11 auf einer Photolackschicht 13 eines Substrats 15 mit Hilfe eines abbildenden optischen Systems 17 erzeugt wird, das beispielsweise eine brechende Projektionslinse aufweist. Das System könnte aber auch ohne weiteres ein Vergrösserungsverhältnis von 1:1 aufweisen und andere sammelnde optische Elemente enthalten, beispielsweise Spiegel oder eine Kobination aus brechenden und spiegelnden Elementen. Eine Lichtquelle 19, beispielsweise eine Quecksilberlampe mit geeigneten Filtern und Blenden (nicht dargestellt), und ein Kondensor 21 sind vorgesehen. Die Maske 11 besteht üblicherweise aus einem durchsichtigen Träger 23, beispielsweise Borsilicatglas oder Quarz mit undurchsichtigen Gebieten 25, die beispielsweise mit Chrom oder Silber auf der Oberfläche 12 erzeugt werden und ein Muster aus benachbarten Gebieten mit im Idealfall 0% oder 100% Lichtdurchlässigkeit für die Quelle 19 ergeben. Die Abmessungen der einzelnen Gebiete eines Maskenmusters für die Herstellung integrierter Schaltkreise liegen im Bereich von ungefähr 1 bis 100 µm. Nach dem Ausführungsbeispiel der Erfindung ist über der Maske 11 eine Schutzfolie 14 angeordnet, die an Hand von Fig. 2 näher erläutert wird.

Die Maske 11 kann als quadratisches Substrat 23 aus Borsilicatglas mit einem Muster undurchsichtiger Chromflächen auf der Oberfläche 12 hergestellt werden. Die Schutzfolie 14 liegt auf einem Abstandsring 16, der auf die Oberfläche 12 geklebt ist. Ein dünner durchsichtiger Film oder eine Folie 18 wird über den Montagering 37 gespannt und daran fixiert (siehe Fig. 38). Die Folie 18 muss durchsichtig sein und eine Dicke von ungefähr 0,2 bis 6 µm aufweisen, so dass sie den optischen Weg des Belichtungssystems in möglichst geringer Weise beeinflusst. Derartige Dikken führen nur zu einer Verschiebung von 0,67 bis 2 µm des Objekts. Durch die Anwesenheit der Folie braucht daher keine Kompensierung durch Verschiebung der Maske oder der Bildebene zu erfolgen. Da die dünne Folie weiterhin keine Abbildungsfehler hervorruft, ist auch der Abstand zur Maske nicht begrenzt. Dies stellt einen Vorteil gegenüber der Verwendung eines Glassandwiches dar, wenn ein grösserer Abstand bei Systemen mit hoher Vergrösserung (beispielsweise zehn- bis zwanzigfach) wünschenswert ist oder wenn die Reinraumbedingungen weniger streng sind. Geeignete Folienmaterialien sind beispielsweise Polymerfolien, wie Polyäthylenterephthalat, das unter dem Warenzeichen «Mylar» verkauft wird, Nitrocellulose und Parylen. Die Folie kann auch mit Anti-Reflexschichten versehen werden, um die Auswirkungen auf das Belichtungssystem weiter zu verringern.

Die Schutzfolie kann entsprechend der Darstellung in den Figuren 3A und 3B hergestellt werden. Eine Folie 18 aus Mylar mit einer Dicke von 2,5 µm ist zwischen den beiden Ringen 31 und 33 eingespannt. Die geschlossenen Ringe werden dann mit Hilfe eines Anschlags 35 so verschoben, dass die Folie 18 über den Montagering 37 gespannt wird. Die Folie wird mit einem Klebstoff am Ring festgeklebt und der überschüssige Film am Rand des Rings 37 entfernt. Mit diesem Verfahren können Folien hergestellt werden, deren Radialspannung von Ring zu Ring nahezu konstant ist.

Der Abstand der Folie von dem Maskenmuster wird entsprechend der Grösse der Schmutzpartikel eingestellt, die in der betreffenden Umgebung zu erwarten sind. Welcher Abstand zur unscharfen Abbildung der Teilchen einer bestimmten Grösse erforderlich ist, hängt von der numerischen Apertur des Belichtungssystems ab. Aus der graphischen Darstellung in Fig. 4 können die Teilchengrössen entnommen werden, die bei einem bestimmten Abstand in einem Projektionssystem unscharf abgebildet werden, dessen numerische Apertur 0,05 auf der Maskenseite beträgt. Beispielsweise entsprechen alle Punkte im Bereich I Verschmutzungen und Fehlern, die noch abgebildet werden. Im Bereich III entsprechen alle Punkte Fehlstellen, die nicht abgebildet werden. Im Bereich II entsprechen alle Punkte solchen Fehlstellen, deren Abbildung von der Durchlässigkeit des Schmutzteilchens und der Kohärenz des Belichtungssystems abhängt. Als Beispiel für die Wahl des Abstands soll als Verschmutzung eine Teilchengrösse von ungefähr 35 µm angenommen werden; aus der Darstellung in Fig. 4 ergibt sich dann der minimale Abstand, bei dem 35 µm-Teilchen nicht mehr abgebildet werden, zu ungefähr 4,4 mm. In der Umgebung eines typischen Projektionsbelichtungssystems kann man vernünftigerweise Schmutzteilchen im Bereich bis zu einem Maximum von ungefähr 50 µm erwarten, entsprechend der Grösse von Hautschuppen. Ein Abstand von ungefähr 6 mm verhindert mit ausreichender Sicherheit die Abbildung derartiger Teilchen.

Die Kurven in Fig. 4 wurden unter der Annahme eines Kontrastverlustes von 90% bestimmt. Für einen davon verschiedenen Kontrastverlust ergeben sich andere Diagramme. Ausserdem gilt die Darstellung in Fig. 4 für ein Belichtungssystem mit einer bestimmten numerischen Apertur. Systeme mit anderen numerischen Aperturen führen zu Abständen, die von den aus Fig. 4 zu bestimmenden verschieden sind, wenn die Abbildung von Verschmutzungsteilchen einer bestimmten Grösse verhindert werden soll. Im folgenden werden einige Referenzen bezüglich der Berechnung von Kontrastverlusten in optischen Systemen aufgrund von Abbildungsfehlern (d.h. defokussieren) angegeben.

W.H. Steel, Revue d'Optique, Band 31, 1972, Seite 334; Band 32, 1953, Seite 4; W.H. Steel, Optica Acta, Band 3, 1956, Seite 65; H.H. Hopkins, Proceedings of the Physical Society A, Band 231, 1955, Seite 91; B, Band 55, 1943, Seiten 116; Band 69, 1956, Seite 562; Band 70, 1956, Seiten 449, 1002 und 1162; A. Marechal, Diffraction – Structur des Images – Paris, 1970.

Aus den Diagrammen in Fig. 4 ergibt sich, dass ein Abstand von ungefähr 6 mm ausreicht, um das Abbilden der grössten Teilchen zu verhindern, die in normalen, bei der Photolithographie verwendeten Reinräumen erwartet werden können. Für praktische Zwecke liegt der Bereich der Abstände zwischen der Folie und der Ebene des Belichtungsmusters zwischen 1 und 125 mm, wenn Belichtungssysteme zur Mehrfachbelichtung (step and repeat) und hoher Vergrösserung (beispielsweise zehn- und zwanzigfach) verwendet werden und normale Reinraumbedingungen vorliegen.

Ausser zum Schutz der Maskenebene kann eine ähnliche Schutzfolie auch in der Bildebene verwendet werden, um das lichtempfindliche Substrat zu schützen. Dies ist die Fig. 1 an Hand der Schutzfolie 20 auf dem Träger 22 über dem Substrat 15 dargestellt. Dadurch wird verhindert, dass Verunreinigungsteilchen auf solche Teile der lichtempfindlichen Schicht gelangen, die belichtet werden müssen und deren Belichtung verhindern. Die Schutzfolie 20 kann auch an dem Halbleiterplättchen selbst befestigt werden.

## Patentansprüche

1. Belichtungsmaske für Projektionsbelichtungssysteme, dadurch gekennzeichnet, dass über der beschichteten Fläche (12) des Maskensubstrats (23) eine durchsichtige Schutzfolie (14) mit einer Dicke im Bereich von 0,6 μ bis 6 μ in einem Abstand im Bereich von 1 bis 125 mm angebracht ist.

2. Belichtungsmaske nach Anspruch 1, dadurch gekennzeichnet, dass die Schutzfolie aus Polymerfilmen besteht, z.B. Polyäthylenterephthalat, Nitrocellulose oder Parylen.

3. Belichtungsmaske nach Anspruch 1 oder 2, dadurch gekennzeichnet, dass die Schutzschicht auf einen Montagering (37) aufgespannt ist und von einem Abstandsring (16) gehalten wird.

4. Projektionsbelichtungssystem zur Abbildung einer Maske auf eine lichtempfindliche Schicht, dadurch gekennzeichnet, dass über der Maskenoberfläche (12) und/oder der lichtempfindlichen Schicht (13) eine durchsichtige Schutzfolie (14 bzw. 20) mit einer Dicke im Bereich von 0,6 bis 6 μm in einem Abstand im Bereich von 1 bis 125 mm angeordnet ist.

## Claims

1. Exposure mask for projection exposure systems, characterized in that over the coated surface (12) of the mask substrate (23) a transparent cover film (14) with a thickness between 0.6 μ and 6 μ is provided at a distance ranging from 1 to 125 mm.

2. Exposure mask as claimed in claim 1, characterized in that the cover film consists of polymer films, e.g. polyethylene terephthalate, nitrocellulose, or parylene.

3. Exposure mask as claimed in claim 1 or 2, characterized in that the cover is stretched over a mounting ring (37) and fixed by a spacer ring (16).

4. Projection exposure system for imaging a mask onto a light sensitive layer, characterized in that over the mask surface (12) and/or the light sensitive layer (13) a transparent cover film (14 or 20, respectively) of a thickness between 0.6 to 6 μm is arranged distanced therefrom between 1 to 125 mm.

## Revendications

1. Masque d'exposition destiné à des systèmes d'exposition par projection, caractérisé en ce que une pellicule transparente de protection (14) d'une épaisseur de 0,6 à 6 μ est appliquée à une distance allant de 1 à 125 mm sur la surface recouverte (12) du substrat de masque.

2. Masque d'exposition selon la revendication 1, caractérisé en ce que la pellicule de protection est composée de films polymères tels que le téréphtalate de polyéthylène, la nitrocellulose, ou le parylène.

3. Masque d'exposition selon la revendication 1 ou 2, caractérisé en ce que la couche protectrice est étendue sur un anneau de montage (37) et maintenue par un anneau d'écartement (16).

4. Système d'exposition par projection destiné à reproduire un masque sur une couche photo-sensible, caractérisé en ce que une pellicule transparente de protection (14 ou 20 respectivement), d'une épaisseur de 0,6 à 6 μ est appliquée sur la surface de masque (12) et/ou sur la couche photo-sensible (13) à une distance allant de 1 à 125 mm.

FIG. 1

FIG. 3A

FIG. 2

FIG. 3B

FIG. 4

GRÖSSE DES FEHLERS IN DER MASKENEBENE $\mu$ m

I ABBILDUNGS-BEREICH

II UNSICHERER BEREICH

III BEREICH OHNE ABBILDUNG

• • • INKOHÄRENT

✳ ✳ ✳ KOHÄRENT

ABSTAND DER FOLIE VON DER MASKENEBENE e (mm)